# EUROPEAN PATENT SPECIFICATION

(11) **EP 3 944 300 B1**
(45) Date of publication and mention of the grant of the patent: **31.07.2024**
(21) Application number: 21785736.6
(22) Date of filing: 26.03.2021
(51) Int. Cl.: H01L 21/308, H01L 21/762

(54) **METHOD FOR PREPARING SEMICONDUCTOR STRUCTURE**
VERFAHREN ZUR HERSTELLUNG EINER HALBLEITERSTRUKTUR
PROCÉDÉ DE PRÉPARATION D'UNE STRUCTURE SEMI-CONDUCTRICE

(30) Priority: 20.05.2020 CN 202010428539
(43) Date of publication of application: 26.01.2022
(73) Proprietor: Changxin Memory Technologies, Inc., Hefei City, Anhui 230000 (CN)
(72) Inventor: ZHU, Yiming, Hefei Anhui 230000 (CN); YING, Zhan, Hefei Anhui 230000 (CN); ZHANG, Qiang, Hefei Anhui 230000 (CN)
(74) Representative: V.O.
(86) International application number: PCT/CN2021/083131
(87) International publication number: WO 2021/232937

(56) References cited:
- EP-A1- 3 944 301
- CN-A- 101 577 242
- CN-A- 107 275 286
- CN-A- 107 275 286
- US-A1- 2012 126 374
- US-A1- 2015 108 601
- US-A1- 2018 006 111
- US-B1- 10 559 568
- US-B1- 9 842 931

## Description

### TECHNICAL FIELD

The present application relates to a method for manufacturing a semiconductor structure.

### BACKGROUND

A dynamic random access memory (DRAM) is a semiconductor memory widely used in computing systems. As semiconductor integrated circuit device technology continues to advance, the critical size of the dynamic random access memory becomes smaller and smaller. For example, the size of the active area of a memory becomes smaller, which has very high requirement on semiconductor manufacturing processes. Background may be found in US 9 842 931B1, US 2018/006111A1 and US 2012/126374A1. Background may also be found in US 2015/108601A1.

### SUMMARY

Embodiments of the present application provide a method for manufacturing a semiconductor structure.

The invention is set out in the appended set of claims.

The details of one or more embodiments of the present application are set forth in the following drawings and description. Other features and advantages of the present application will become apparent from the description, drawings and claims.

### BRIEF DESCRIPTION OF THE DRAWINGS

In order to more clearly illustrate the technical solutions in the embodiments of the present application, the following will briefly introduce the drawings that need to be used in the embodiments. It is apparent that the drawings in the following description are only some embodiments of the present application. Those of ordinary skill in the art can also obtain other drawings from these drawings without creative work.
FIG. 1 illustrates a flowchart of a method for manufacturing a semiconductor structure according to various embodiments of the present invention.
FIG. 2 illustrates a three-dimensional structural diagram of a substrate having multiple first trenches which is obtained by Step S1 in a method for manufacturing a semiconductor structure according to various embodiments of the present invention.
FIG. 3 illustrates a three-dimensional structural diagram of a semiconductor structure obtained by Step S2 in a method for manufacturing a semiconductor structure according to various embodiments of the present invention.
FIG. 4 illustrates a three-dimensional structural diagram of a semiconductor structure obtained after removing a first dielectric layer located at bottom surfaces of the first trenches in a method for manufacturing a semiconductor structure according to various embodiments of the present invention.
FIG. 5 illustrates a three-dimensional structural diagram of a semiconductor structure obtained by Step S3 in a method for manufacturing a semiconductor structure according to various embodiments of the present invention.
FIG. 6 illustrates a three-dimensional structural diagram of a semiconductor structure obtained by Step S42 in a method for manufacturing a semiconductor structure according to various embodiments of the present invention.
FIG. 7 illustrates a three-dimensional structural diagram of a semiconductor structure obtained by Step S5 in a method for manufacturing a semiconductor structure according to various embodiments of the present invention.
FIG. 8 illustrates a three-dimensional structural diagram of a semiconductor structure obtained by Step S6 in a method for manufacturing a semiconductor structure according to various embodiments of the present invention.

Reference signs:
1. Substrate; 11. First pattern; 111. Second pattern; 112. Second trench; 12. First trench; 2. First dielectric layer; 3. Patterned mask layer; 31. Opening pattern; 4. Second dielectric layer; 5. Third dielectric layer.

### DETAILED DESCRIPTION OF THE EMBODIMENTS

When the width of the active area becomes very small, use of existing etching process to etch and form the active area may damage the ends of the elongated active area.

To better understand the objectives, technical solutions, and technical effects of the present invention, the following disclosure describes the present invention with reference to drawings and various embodiments. Further, various embodiments described herein are merely used to illustrate the present invention, and not to limit the present invention.

Unless stated otherwise, all technical and scientific terms used herein have the same meanings as those commonly understood by a person skilled in the art. Terms used herein are merely intended to describe specific embodiments, and not intended to limit the present application. The term "and/or" used herein includes any and all combinations of one or more related listed items.

In the case of using "include", "have", and "comprise" described herein, another component or method can further be added unless explicit qualifiers, such as "only" and "consist of', are used. Unless stated to the contrary, terms in the singular forms can include the plural forms and cannot be construed to mean a quantity of one.

In conventional semiconductor processes, dry etching is performed on a substrate through a one-step etching process to form shallow trenches on the substrate, so that a plurality of active areas can be separated on the substrate. Insulating material layers are then filled into the shallow trenches to form a trench isolation structure. In particular, as the size of a semiconductor structure decreases, ends of active areas can be more elongated. when a dry etching process is used to directly etch the substrate to form the active areas, etching gas used in the dry etching process can contain high-energy charged particles or groups, so that as the substrate is bombarded with the high-energy charged particles or groups to form the shallow trenches, the ends of the active areas can be damaged or destroyed, thereby causing adverse impact to performance of the device.

Therefore, based on the problems described above, a method for manufacturing a semiconductor structure is required, so as to reduce damage to ends of an active area during an etching process.

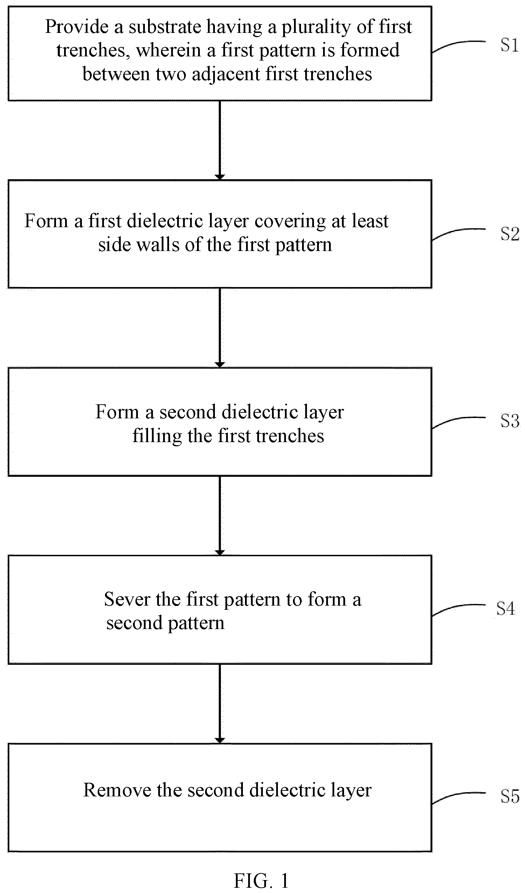

As shown in FIG. 1, the present invention provides a method for manufacturing a semiconductor structure. The method includes the following steps.

At Step S1, a substrate having a plurality of first trenches is provided. A first pattern is formed between two adjacent first trenches.

At Step S2, a first dielectric layer is formed. The first dielectric layer covers at least side walls of the first pattern.

At Step S3, a second dielectric layer is formed. The second dielectric layer fills the first trenches.

At Step S4, the first pattern is severed to form a second pattern.

At Step S5, the second dielectric layer is removed.

According to the method for manufacturing the semiconductor structure of the present invention, the first dielectric layer is formed on the at least one side wall of the first pattern in the substrate as a protective layer. The first pattern is severed to form the second pattern constituting active areas. As such, when the first pattern is severed to form the second pattern constituting the active areas, because the side walls of the first pattern are protected by the first dielectric layer, ends of the second pattern (i.e., ends of the active areas) formed by severing can be better protected in severing processes.

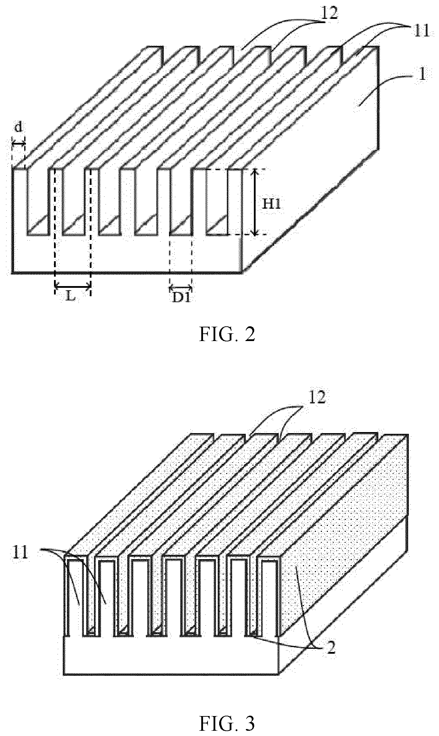

As shown in FIG. 2, the Step S1 includes the following steps.

At Step S11, the substrate 1 is provided.

At Step S12, the substrate 1 is etched to form the first trenches 12 on the substrate 1. A first pattern 11 is formed between two adjacent first trenches 12.

In various embodiments, the substrate 1 can be, but is not limited to, a silicon substrate, a gallium nitride substrate, a silicon-on-insulator, a silicon carbide substrate, or the like. In one embodiment, the substrate 1 can be a silicon substrate. Doped well regions may be formed on the substrate 1 through an ion implantation process. A doped well region can either be P-type or N-type.

In some embodiments, the first pattern 11 and the first trenches 12 can constitute a strip-shaped array structure. The first pattern 11 can be plate-shaped wall structures. Specifically, the first pattern 11 can be, but are not limited to, rectangular plate-shaped wall structures. Multiple first patterns 11 can be spaced apart in an array by the first trenches 12 formed between two adjacent first patterns 11. Specifically, the multiple first patterns 11 are parallelly spaced.

In some embodiments, as shown in FIG. 2, a width d of the first pattern 11 in the Step S12 can be set based on actual needs. The width d can be a length of a cross section perpendicular to an extension direction of the first pattern 11 in a horizontal direction of the substrate 1. Preferably, the width d of the first patterns 11 can be less than or equal to 20 nm. More specifically, the width d of the first pattern 11 can be 20 nm, 15 nm, or 10 nm, or the like. Within this width range, the technical problem described in the present invention can be more pronounced, and the technical solutions described herein can have better economical and beneficial technical effects. A distance L between adjacent first patterns 11 can be set based on actual needs. Specifically, the distance L between adjacent first patterns 11 can be less than or equal to 30 nm. More specifically, the distance L between adjacent first patterns 11 can be 30 nm, 25 nm, 20 nm, 15 nm, or 10 nm, or the like. In other embodiments, the distance L between adjacent first patterns 11 is not limited to the above distances. It should be noted that, for the distance L between adjacent first patterns 11 being of less than or equal to 30 nm, this distance is referred to as a center-to-center distance between two adjacent first patterns 11.

In some embodiments, in the Step 12, a self-aligned double patterning (SADP) process or a self-aligned quadruple patterning (SAQP) process can be used to form the strip-shaped array structure on the substrate 1 including the first patterns 11 and the first trenches 12. The SADP process and the SAQP process are known to a person skilled in the art and are not described in detail herein.

In some embodiments, as shown in FIG. 3, the Step S2 includes the following steps.

The first dielectric layer 2 is formed onto side surfaces and bottom surfaces of the first trenches 12. In such a case, the first dielectric layer 2 can serve as a protective layer. Optionally, the first dielectric layer 2 can be formed on the side surfaces of the first trenches 12, the bottom surfaces of the first trenches 12, and top surfaces of the first patterns 11. In this way, the first dielectric layer 2 can effectively protect the first pattern 11 from subsequent etching of second trenches.

Specifically, a thicknesses of the first dielectric layer 2 can be determined based on actual needs. More specifically, the thicknesses of the first dielectric layer 2 can be less than half of a width of the first trenches 12. In such a case, there can still be gaps within the first trenches 12 after the first dielectric layer 2 is formed. Preferably, the thickness of the first dielectric layer 2 can range from 1 nm to 5 nm. In this range, the first dielectric layer 2 not only can provide enough protection for the first pattern 11, it can also leave enough space for subsequent filling of a third dielectric layer.

In various embodiments, the first dielectric layer 2 can be formed through a physical vapor deposition process, a chemical vapor deposition process, an atomic layer deposition process, a thermal oxidation process, or the like. The first dielectric layer 2 which serves as the protection layer can be, but not limited to, a silicon dioxide (SiO₂) layer, a silicon monoxide (SiO) layer, a silicon nitride (SiN) layer, a silicon oxynitride (SiON) layer, or the like. In some embodiments, the first dielectric layer 2 can be a silicon dioxide layer.

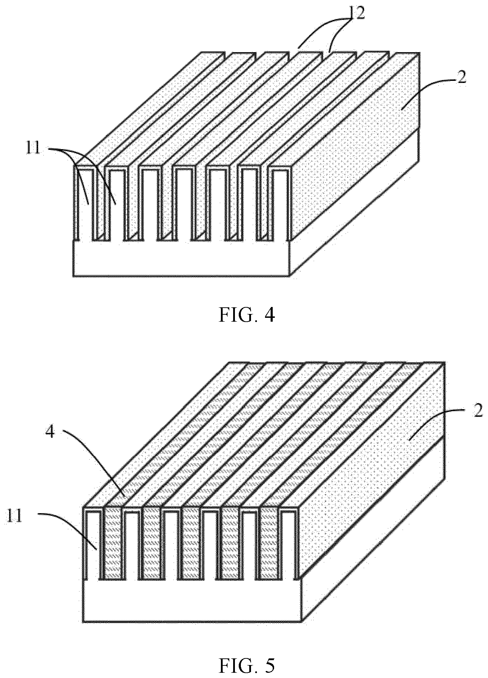

In some embodiment, as shown in FIG. 4, after forming the first dielectric layer 2 and before forming the second dielectric layer 4, the method further includes: the first dielectric layer 2 located at bottom surfaces of the first trenches 12 are removed. As such, the bottom surfaces of the first dielectric layer 2 are separated to form a discontinuous separation structure. In this way, accumulation of charge carriers at the bottom surfaces of the first trenches 12 can be avoided. Therefore, electric leakage caused by the accumulation of holes or electrons in the transistor substrate near the first dielectric layer 2 can be avoided. It should be noted that, all or some of the first dielectric layer 2 at the bottom surfaces of the first trenches 12 can be removed. In some embodiments, all of the first dielectric layer 2 at the bottom surfaces of the first trenches 12 are removed. Specifically, the first dielectric layer 2 located at the bottom surfaces of the first trenches 12 can be removed through a dry etching process or the like.

As shown in FIG. 5, the Step S5 includes the following steps.

The second dielectric layer 4 is formed within the first trenches 12. The second dielectric layer 4 fills the first trenches 12.

In various embodiments, the second dielectric layer 4 can be formed through a physical vapor deposition process, a chemical vapor deposition process, an atomic layer deposition process, a spin-coating process, or the like. A material of the second dielectric layer 4 can be different from a material of the first dielectric layer 2. Specifically, a hardness of the first dielectric layer 2 can be greater than a hardness of the second dielectric layer 4. In this way, the first dielectric layer 2 can provide better protection for the first pattern 11, and moreover, a removal rate of the second dielectric layer 4 can be higher than a removal rate of the first dielectric layer 2 under the same etching condition. This difference in removal rates ensures that the first dielectric layer 2 on upper surfaces of the first pattern 11 is more resistant to removal in subsequent removal of the second dielectric layer 4. More specifically, in some embodiments, the second dielectric layer 4 can be, but not limited to, a spin-on carbon (SOC) layer, a spin-on glass (SOG) layer, or the like. In general, any material layer that meets the above criteria can be used herein.

More specifically, the Step S3 includes the following steps.

At Step 31, a second dielectric material layer (not shown) is formed. The second dielectric material layer fills the first trenches 12 and covers the first dielectric layer 2 on upper surfaces of the first patterns 11. Specifically, the second dielectric material layer can be formed through a physical vapor deposition process, a chemical vapor deposition process, an atomic layer deposition process, a spin-coating process, or the like.

At Step 32, the second dielectric material layer that covers the first dielectric layer 2 on upper surfaces of the first patterns 11 is removed while retaining the second dielectric material layer (i.e., the second dielectric layer 4) in the first trenches 12. Specifically, the second dielectric material layer that covers the first dielectric layer 2 on the upper surfaces of the first patterns 11 can be removed through a chemical mechanical polishing process or the like. In other examples, the second dielectric material layer is also located on the first dielectric layer 2 of the upper surfaces of the first patterns 11. The second dielectric material layer on the first dielectric layer 2 of the upper surfaces of the first patterns 11 and the second dielectric material layer in the first trenches 12 have a continuous flat upper surface.

The Step S4 includes the following step. Multiple second trenches 112 are formed on each of the first patterns 11 to cut the first pattern 11 into multiple second patterns 111.

Specifically, the Step S4 includes the following steps.

At Step S41, a mask layer is formed on the upper surface of the substrate 1.

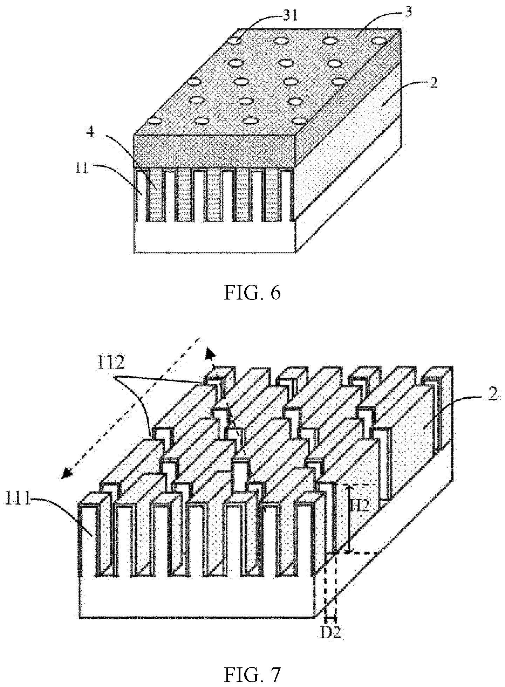

At Step S42, the mask layer is patterned to obtain the patterned mask layer 3. As shown in FIG. 6, the patterned mask layer 3 can include a plurality of opening patterns 31 penetrating through the mask layer. The plurality of opening patterns 31 can define positions and shapes of the second trenches. Optionally, shapes of the opening patterns 31 can be circular, elliptical, rectangular, or the like.

At Step S43, the first patterns 11 can be etched based on the patterned mask layer 3 to form the multiple second trenches 112 on each of the first patterns 11. In this way, each of the first patterns 11 can be cut into the multiple second patterns.

At Step S44, the patterned mask layer 3 is removed.

In various embodiments, in the Step S41, the mask layer can be, but is not limited to, an amorphous carbon layer, a silicon oxynitride layer, a silicon oxide layer, or a combination of at least two of the aforementioned layers. Specifically, the mask layer can be formed through at least one of a physical vapor deposition process, a chemical vapor deposition process, an atomic layer deposition process, a spin-coating process, or the like.

In some embodiments, in the Step S42, the mask layer can be patterned based on a photolithography process to obtain the patterned mask layer 3. In some embodiments, a size of the plurality of opening patterns 31 can be greater than the width of the first pattern 11. Specifically, the size of the plurality of opening patterns 31 can be a size in a width direction of the first pattern 11. In some cases, the size of the plurality of opening patterns 31 can be a maximum size in a horizontal direction of the substrate. For instance, the width of the first pattern 11 can be less than or equal to 20 nm, the size of the second trenches 112 can be less than or equal to 15 nm, the thickness of the first dielectric layer 2 can range from 1 nm to 5 nm, and the size of the plurality of opening patterns 31 can be less than 30 nm. In general, allowing the size of the plurality of opening patterns 31 to be greater than the width of the first pattern 11 can be helpful in increasing a process window and increasing a product yield. It should be noted that, the size of the second trenches 112 can be a size in the width direction of the first pattern 11, or in some cases, can be a maximum size in the horizontal direction of the substrate.

In some embodiments, In the Step S43, the first pattern 11 can be etched based on the patterned mask layer 3 through a dry etching process. In some embodiments, the second trenches 112 is separated from the first pattern 11 without separating the first dielectric layer 2 on the side walls of the first pattern 11. Specifically, the first pattern 11 can be etched to form the second trenches 112 using the plurality of opening patterns 31 and through an etching process with an etching selection ratio greater than 8 between the first pattern 11 and the first dielectric layer 2. The second patterns 111 are formed between the first trenches 12 and the second trenches 112. The first dielectric layer 2 on the side walls of the first pattern 11 is not separated during the etching process. An etching process with a high etching selection ratio is used to only etch and separate the first pattern 11 while retaining the intact first dielectric layer 2. Therefore, shapes of ends of the second pattern 111 can be better ensured, thereby improving performance of the device.

In some embodiments, in the Step S44, the patterned mask layer 3 can be removed through an etching process or a chemical mechanical polishing process.

As shown in FIG. 7, in some embodiments, an extension direction of the first pattern 11 obliquely intersects an arrangement direction of adjacent second trenches 112 spaced apart by a shortest distance in different columns. Specifically, the second trenches 112 on the same first pattern 11 are spaced apart, and the second trenches 112 on adjacent first patterns 11 are staggered. More specifically, the second trenches 112 of the first patterns 11 in odd columns are staggered with the second trenches 112 of the first patterns 11 in even columns. The second trenches 112 of the adjacent first patterns 11 in odd columns are in one-to-one correspondences. The second trenches 112 of the adjacent first patterns 11 in even columns are in one-to-one correspondences. In some embodiments, the first pattern 11 can be active areas of a storage device, and the above arrangement manner helps maximize a storage density of the storage device.

In some embodiments, as shown in FIG. 2 and FIG. 7, a depth H1 of the first trenches 12 can be greater than or equal to a depth H2 of the second trenches 112. In such embodiments, the depth H1 of the first trenches 12 can be greater than the depth H2 of the second trenches 112. Allowing the depth of the first trenches 12 to be greater than the depth of the second trenches 112 can achieve a better separation effect and avoid mutual impact between adjacent active areas. Specifically, the depth H1 of the first trenches 12 can be etched differently than the depth H2 of the second trenches 112 by etching the first trenches 12 first and etching the second trenches 112 second through any of the aforementioned etching processes, that is, by etching the substrate 1 twice.

In some embodiments, as shown in FIG. 2 and FIG. 7, a width D1 of the first trenches 12 can be less than or equal to a width D2 of the second trenches 112. In such embodiments, the width D1 of the first trenches 12 can be less than the width D2 of the second trenches 112. It should be noted that, the width of the second trenches 112 refers to a size in the extension direction of the first pattern 11.

In the Step S5, the second dielectric layer 4 located in the first trenches 12 is removed, as shown in FIG. 7.

For example, the second dielectric layer 4 in the first trenches 12 can be removed by using a wet etching process or a dry etching process. Specifically, in this embodiment, the second dielectric layer 4 in the first trenches 12 can be removed by using a wet etching process. More specifically, the second dielectric layer 4 in the first trenches 12 can be removed by using an etchant solution, and the etchant solution does not remove the first dielectric layer 2 on upper surfaces of the first patterns 11 and not remove the substrate 1.

In some embodiments, after removing the second dielectric layer 4 in the first trenches 12, the method further includes the following step.

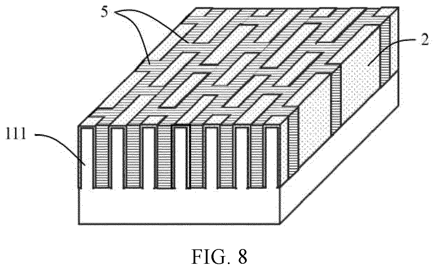

At Step S6, a third dielectric layer 5 is filled into the first trenches 12 and the second trenches 112. The third dielectric layer 5 fills the first trenches 12 and the second trenches 112, and no first dielectric layer 2 exists between the third dielectric layer 5 in the second trenches 112 and the second patterns 111, as shown in FIG. 8. Specifically, the third dielectric layer 5 in the first trenches 12 is in direct contact with the first dielectric layer 2, and third dielectric layer 5 in the second trenches 112 is in direct contact with the second patterns 111.

In some embodiments, the third dielectric layer 5 can be formed through a physical vapor deposition process, a chemical vapor deposition process, an atomic layer deposition process, a spin-coating process, or the like. A material of the third dielectric layer 5 can be same as the material of the first dielectric layer 2. In some cases, the material of the third dielectric layer 5 can be different from the material of the first dielectric layer 2. Specifically, the third dielectric layer 5 can be, but are not limited to, a silicon dioxide (SiO2) layer or a silicon nitride (SiN) layer. Finally, the third dielectric layer 5 and the first dielectric layer 2 can jointly serve as a shallow trench isolation structure.

The manufacturing process of the present invention is simple, has broad application prospects in the field of semiconductor manufacturing, can effectively overcome shortcomings of existing technologies, and has high industrial utilization value.

The previously described embodiments represent merely a few embodiments of the present invention with specific and detailed descriptions, but are not construed as a limitation to the scope of the present invention. It should be noted that, variations and modifications that can further be made by a person skilled in the art without departing from the concept of the present invention all fall within the protection scope of the present invention. Therefore, the protection scope of the present invention should be subject to the appended claims.

## Claims

1. A method for manufacturing a semiconductor structure, comprising the following sequential steps of:
providing (S1) a substrate (1) having a plurality of first trenches (12), wherein each of a plurality of first patterns (11) is formed between two adjacent first trenches (12);
forming (S2) a first dielectric layer (2), the first dielectric layer (2) covering at least side walls of the first pattern (11);
forming (S3) a second dielectric layer (4), the second dielectric layer (4) filling the first trenches (12);
severing (S4) the first pattern (11) to form a plurality of second patterns (111) by forming a plurality of second trenches (112) on the first pattern (11) to cut the first pattern (11) into the plurality of second patterns (111), wherein the second trenches (112) only separate the first pattern (11) without separating the first dielectric layer (2) on the side walls of the first pattern (11) to retain the intact first dielectric layer (2);
removing (S5) the second dielectric layer (4) from the first trenches (12); and
filling (S6) a third dielectric layer (5) in the first trenches (12) and the second trenches (112), wherein no first dielectric layer (2) exists between the third dielectric layer (5) in the second trenches (112) and the second patterns (111).

2. The method for manufacturing the semiconductor structure of claim 1, wherein forming (S2) the first dielectric layer (2), the first dielectric layer (2) covering at least side walls of the first pattern (11) comprises:
forming the first dielectric layer (2) on the side walls of the first pattern (11) and bottom surfaces of the first trenches (12).

3. The method for manufacturing the semiconductor structure of claim 1, wherein forming (S2) the first dielectric layer (2), the first dielectric layer (2) covering at least side walls of the first pattern (11) comprises:
forming the first dielectric layer (2) on the side walls of the first pattern (11), bottom surfaces of the first trenches (12), and an upper surface of the first pattern (11).

4. The method for manufacturing the semiconductor structure of claim 2 or 3, further comprising:
removing the first dielectric layer (2) located at the bottom surfaces of the first trenches (12) after forming (S2) the first dielectric layer (2) and prior to forming (S3) the second dielectric layer (4).

5. The method for manufacturing the semiconductor structure of claim 1, wherein a width of the first pattern (11) is less than or equal to 20 nm; and
wherein a distance between two adjacent first patterns (11) is less than or equal to 30 nm.

6. The method for manufacturing the semiconductor structure of claim 1, wherein a hardness of the first dielectric layer (2) is greater than a hardness of the second dielectric layer (4); and
wherein the first dielectric layer (2) comprises a silicon dioxide layer, and/or, the second dielectric layer (4) comprises a spin-on carbon layer or a spin-on glass layer.

7. The method for manufacturing the semiconductor structure of claim 1, wherein forming the plurality of second trenches (112) on the first pattern (11) to cut the first pattern (11) into the plurality of second patterns (111) comprises:
forming a mask layer on an upper surface of the substrate (1);
patterning the mask layer to obtain a patterned mask layer (3), wherein the patterned mask layer (3) comprises a plurality of opening patterns (31) penetrating through the mask layer, and the plurality of opening patterns (31) define positions and shapes of the second trenches (112); and
etching the first pattern (11) based on the patterned mask layer (3) to form the plurality of second trenches (112) on the first pattern (11) to cut the first pattern (11) into the plurality of second patterns (111).

8. The method for manufacturing the semiconductor structure of claim 1, wherein an extension direction of the first pattern (11) obliquely intersects an arrangement direction of adjacent second trenches (112) spaced apart by a shortest distance in different columns.

9. The method for manufacturing the semiconductor structure of claim 1, wherein a depth of the first trenches (12) is greater than a depth of the second trenches (112);
and/or,
wherein a width of the first trenches (12) is less than a width of the second trenches (112).

10. The method for manufacturing the semiconductor structure of claim 1, wherein the first pattern (11) is separated through an etching process with an etching selection ratio greater than 8 between the first pattern (11) and the first dielectric layer (2).

11. The method for manufacturing the semiconductor structure of claim 7, wherein a size of the plurality of opening patterns (31) is greater than a width of the first pattern (11).

12. The method for manufacturing the semiconductor structure of claim 11, wherein a size of the second trenches (112) is less than 15 nm, a thickness of the first dielectric layer (2) ranges from 1 nm to 5 nm, and the size of the plurality of opening patterns (31) is less than 30 nm.

## Patentansprüche

1. Verfahren zur Herstellung einer Halbleiterstruktur, das die folgenden aufeinanderfolgenden Schritte umfasst:
Bereitstellen (S1) eines Substrats (1) mit einer Vielzahl von ersten Gräben (12), wobei jedes aus einer Vielzahl von ersten Mustern (11) zwischen zwei benachbarten ersten Gräben (12) gebildet wird;
Bilden (S2) einer ersten dielektrischen Schicht (2), wobei die erste dielektrische Schicht (2) zumindest Seitenwände des ersten Musters (11) bedeckt;
Bilden (S3) einer zweiten dielektrischen Schicht (4), wobei die zweite dielektrische Schicht (4) die ersten Gräben (12) ausfüllt;
Trennen (S4) des ersten Musters (11), um eine Vielzahl von zweiten Mustern (111) zu bilden, indem eine Vielzahl von zweiten Gräben (112) auf dem ersten Muster (11) gebildet wird, um das erste Muster (11) in die Vielzahl von zweiten Mustern (111) zu schneiden, wobei die zweiten Gräben (112) nur das erste Muster (11) trennen, ohne die erste dielektrische Schicht (2) an den Seitenwänden des ersten Musters (11) zu trennen, um die intakte erste dielektrische Schicht (2) zu erhalten;
Entfernen (S5) der zweiten dielektrischen Schicht (4) aus den ersten Gräben (12); und
Füllen (S6) einer dritten dielektrischen Schicht (5) in die ersten Gräben (12) und die zweiten Gräben (112), wobei keine erste dielektrische Schicht (2) zwischen der dritten dielektrischen Schicht (5) in den zweiten Gräben (112) und den zweiten Mustern (111) vorhanden ist.

2. Verfahren zur Herstellung der Halbleiterstruktur nach Anspruch 1, wobei das Bilden (S2) der ersten dielektrischen Schicht (2), wobei die erste dielektrische Schicht (2) zumindest Seitenwände des ersten Musters (11) bedeckt, Folgendes umfasst:
Bilden der ersten dielektrischen Schicht (2) auf den Seitenwänden des ersten Musters (11) und den Bodenflächen der ersten Gräben (12).

3. Verfahren zur Herstellung der Halbleiterstruktur nach Anspruch 1, wobei das Bilden (S2) der ersten dielektrischen Schicht (2), wobei die erste dielektrische Schicht (2) zumindest Seitenwände des ersten Musters (11) bedeckt, Folgendes umfasst:
Bilden der ersten dielektrischen Schicht (2) auf den Seitenwänden des ersten Musters (11), den Bodenflächen der ersten Gräben (12) und einer Oberseite des ersten Musters (11).

4. Verfahren zur Herstellung der Halbleiterstruktur nach Anspruch 2 oder 3, ferner umfassend:
Entfernen der ersten dielektrischen Schicht (2), die sich an den Bodenflächen der ersten Gräben (12) befindet, nach dem Bilden (S2) der ersten dielektrischen Schicht (2) und vor dem Bilden (S3) der zweiten dielektrischen Schicht (4).

5. Verfahren zur Herstellung der Halbleiterstruktur nach Anspruch 1, wobei eine Breite des ersten Musters (11) kleiner als oder gleich 20 nm ist; und
wobei ein Abstand zwischen zwei benachbarten ersten Mustern (11) kleiner als oder gleich 30 nm ist.

6. Verfahren zur Herstellung der Halbleiterstruktur nach Anspruch 1, wobei eine Härte der ersten dielektrischen Schicht (2) größer ist als eine Härte der zweiten dielektrischen Schicht (4); und
wobei die erste dielektrische Schicht (2) eine Siliziumdioxidschicht umfasst, und/oder die zweite dielektrische Schicht (4) eine aufgeschleuderte Kohlenstoffschicht oder eine aufgeschleuderte Glasschicht umfasst.

7. Verfahren zur Herstellung der Halbleiterstruktur nach Anspruch 1, wobei das Bilden der Vielzahl von zweiten Gräben (112) auf dem ersten Muster (11), um das erste Muster (11) in die Vielzahl von zweiten Mustern (111) zu schneiden, Folgendes umfasst:
Bilden einer Maskenschicht auf einer Oberseite des Substrats (1);
Strukturieren der Maskenschicht, um eine strukturierte Maskenschicht (3) zu erhalten, wobei die strukturierte Maskenschicht (3) eine Vielzahl von Öffnungsmustern (31) umfasst, die die Maskenschicht durchdringen, und die Vielzahl von Öffnungsmustern (31) Positionen und Formen der zweiten Gräben (112) definieren; und
Ätzen des ersten Musters (11) auf der Grundlage der gemusterten Maskenschicht (3), um die Vielzahl der zweiten Gräben (112) auf dem ersten Muster (11) zu bilden, um das erste Muster (11) in die Vielzahl der zweiten Muster (111) zu schneiden.

8. Verfahren zur Herstellung der Halbleiterstruktur nach Anspruch 1, wobei eine Erstreckungsrichtung des ersten Musters (11) eine Anordnungsrichtung benachbarter zweiter Gräben (112) schräg schneidet, die durch einen kürzesten Abstand in verschiedenen Spalten beabstandet sind.

9. Verfahren zur Herstellung der Halbleiterstruktur nach Anspruch 1, wobei eine Tiefe der ersten Gräben (12) größer ist als eine Tiefe der zweiten Gräben (112);
und/oder,
wobei eine Breite der ersten Gräben (12) geringer ist als eine Breite der zweiten Gräben (112).

10. Verfahren zur Herstellung der Halbleiterstruktur nach Anspruch 1, wobei das erste Muster (11) durch einen Ätzprozess mit einem Ätzauswahlverhältnis von mehr als 8 zwischen dem ersten Muster (11) und der ersten dielektrischen Schicht (2) getrennt wird.

11. Verfahren zur Herstellung der Halbleiterstruktur nach Anspruch 7, wobei eine Größe der Vielzahl von Öffnungsmustern (31) größer als eine Breite des ersten Musters (11) ist.

12. Verfahren zur Herstellung der Halbleiterstruktur nach Anspruch 11, wobei eine Größe der zweiten Gräben (112) weniger als 15 nm beträgt, eine Dicke der ersten dielektrischen Schicht (2) im Bereich von 1 nm bis 5 nm liegt und die Größe der Vielzahl von Öffnungsmustern (31) weniger als 30 nm beträgt.

## Revendications

1. Procédé pour fabriquer une structure semiconductrice, comprenant les étapes séquentielles suivantes de:
fourniture (S1) d'un substrat (1) ayant une pluralité de premières tranchées (12), dans lequel chacun d'une pluralité de premiers motifs (11) est formé entre deux premières tranchées (12) adjacentes;
formation (S2) d'une première couche diélectrique (2), la première couche diélectrique (2) recouvrant au moins les parois latérales du premier motif (11);
formation (S3) d'une deuxième couche diélectrique (4), la deuxième couche diélectrique (4) remplissant les premières tranchées (12);
séparation (S4) du premier motif (11) pour former une pluralité de deuxièmes motifs (111) en formant une pluralité de deuxièmes tranchées (112) sur le premier motif (11) pour découper le premier motif (11) en la pluralité de deuxièmes motifs (111), dans lequel les deuxièmes tranchées (112) séparent seulement le premier motif (11) sans séparer la première couche diélectrique (2) sur les parois latérales du premier motif (11) pour retenir la première couche diélectrique (2) intacte;
retrait (S5) de la deuxième couche diélectrique (4) des premières tranchées (12); et
garnissage (S6) d'une troisième couche diélectrique (5) dans les premières tranchées (12) et les deuxièmes tranchées (112), dans lequel aucune première couche diélectrique (2) n'existe entre la troisième couche diélectrique (5) dans les deuxièmes tranchées (112) et les deuxièmes motifs (111).

2. Procédé pour fabriquer la structure semi-conductrice selon la revendication 1, dans lequel la formation (S2) de la première couche diélectrique (2), la première couche diélectrique (2) recouvrant au moins les parois latérales du premier motif (11) comprend:
la formation de la première couche diélectrique (2) sur les parois latérales du premier motif (11) et les surfaces inférieures des premières tranchées (12).

3. Procédé pour fabriquer la structure semi-conductrice selon la revendication 1, dans lequel la formation (S2) de la première couche diélectrique (2), la première couche diélectrique (2) recouvrant au moins les parois latérales du premier motif (11) comprend:
la formation de la première couche diélectrique (2) sur les parois latérales du premier motif (11), les surfaces inférieures des premières tranchées (12), et une surface supérieure du premier motif (11).

4. Procédé pour fabriquer la structure semi-conductrice selon la revendication 2 ou 3, comprenant en outre:
le retrait de la première couche diélectrique (2) située au niveau des surfaces inférieures des premières tranchées (12) après la formation (S2) de la première couche diélectrique (2) et avant la formation (S3) de la deuxième couche diélectrique (4).

5. Procédé pour fabriquer la structure semiconductrice selon la revendication 1, dans lequel une largeur du premier motif (11) est inférieure ou égale à 20 mm; et
dans lequel une distance entre deux premiers motifs (11) adjacents est inférieure ou égale à 30 nm.

6. Procédé pour fabriquer la structure semi-conductrice selon la revendication 1, dans lequel une dureté de la première couche diélectrique (2) est supérieure à une dureté de la deuxième couche diélectrique (4); et
dans lequel la première couche diélectrique (2) comprend une couche de dioxyde de silicium, et/ou la deuxième couche diélectrique (4) comprend une couche de carbone appliquée par rotation ou une couche de verre appliquée par rotation.

7. Procédé pour fabriquer la structure semi-conductrice selon la revendication 1, dans lequel la formation de la pluralité de deuxièmes tranchées (112) sur le premier motif (11) pour découper le premier motif (11) en la pluralité de deuxièmes motifs (111) comprend:
la formation d'une couche de masque sur une surface supérieure du substrat (1);
la formation de motifs dans la couche de masque pour obtenir une couche de masque à motifs (3), dans lequel la couche de masque à motifs (3) comprend une pluralité de motifs d'ouverture (31) pénétrant à travers la couche de masque, et la pluralité de motifs d'ouverture (31) définissent des positions et des formes des deuxièmes tranchées (112); et
la gravure du premier motif (11) sur la base de la couche de masque à motifs (3) pour former la pluralité de deuxièmes tranchées (112) sur le premier motif (11) pour découper le premier motif (11) en la pluralité de deuxièmes motifs (111).

8. Procédé pour fabriquer la structure semi-conductrice selon la revendication 1, dans lequel une direction d'extension du premier motif (11) coupe obliquement une direction d'agencement de deuxièmes tranchées (112) adjacentes espacées d'une distance la plus courte dans différentes colonnes.

9. Procédé pour fabriquer la structure semi-conductrice selon la revendication 1, dans lequel une profondeur des premières tranchées (12) est supérieure à une profondeur des deuxièmes tranchées (112);
et/ou,
dans lequel une largeur des premières tranchées (12) est inférieure à une largeur des deuxièmes tranchées (112).

10. Procédé pour fabriquer la structure semi-conductrice selon la revendication 1, dans lequel le premier motif (11) est séparé par un processus de gravure avec un rapport de sélection de gravure supérieur à 8 entre le premier motif (11) et la première couche diélectrique (2).

11. Procédé pour fabriquer la structure semi-conductrice selon la revendication 7, dans lequel une taille de la pluralité de motifs d'ouverture (31) est supérieure à une largeur du premier motif (11).

12. Procédé pour fabriquer la structure semi-conductrice selon la revendication 11, dans lequel une taille des deuxièmes tranchées (112) est inférieure à 15 nm, une épaisseur de la première couche diélectrique (2) va de 1 nm à 5 nm, et la taille de la pluralité de motifs d'ouverture (31) est inférieure à 30 nm.
